Europäisches Patentamt

European Patent Office

Office européen des brevets

(19)

(11) Veröffentlichungsnummer: **0 115 009**
**A2**

(12) # EUROPÄISCHE PATENTANMELDUNG

(21) Anmeldenummer: **83112732.9**

(51) Int. Cl.³: **H 03 J 7/18**

(22) Anmeldetag: **17.12.83**

(30) Priorität: **29.01.83 DE 3302971**

(43) Veröffentlichungstag der Anmeldung:
**08.08.84 Patentblatt 84/32**

(84) Benannte Vertragsstaaten:
**CH FR GB IT LI**

(71) Anmelder: **Blaupunkt-Werke GmbH**
**Robert-Bosch-Strasse 200**
**D-3200 Hildesheim(DE)**

(72) Erfinder: **Eilers, Norbert, Dipl.-Phys.**
**Seebothstrasse 19**
**D-3200 Hildesheim(DE)**

(74) Vertreter: **Eilers, Norbert, Dipl.-Phys.**
**Blaupunkt-Werke GmbH Robert-Bosch-Strasse 200**
**D-3200 Hildesheim(DE)**

(54) **Hör- oder Fernsehrundfunksignalempfänger.**

(57) Es wird ein Rundfunksignalempfänger beschrieben, der eine automatische Belegung vorbestimmter Programmtasten mit den zugehörigen Sendern sicherstellt.

EP 0 115 009 A2

Croydon Printing Company Ltd.

FIG. 1

Hör- oder Fernsehrundfunksignalempfänger

Die Erfindung betrifft einen Hör- oder Fernsehrundfunksignalempfänger nach dem Oberbegriff des Hauptanspruchs.

Die Erfindung geht aus von dem Bedürfnis vieler Fernsehgerätebesitzer, stets dasselbe Programm bei Betätigung bestimmter Tasten empfangen zu können, gleichgültig, wo sie sich mit ihrem Empfänger aufhalten. Bisher ist bei einem Ortswechsel des Gerätes eine aufwendige manuelle Neuprogrammierung erforderlich.

Die Erfindung nutzt die Tatsache aus, daß künftig die Hör- oder Fernsehrundfunksignale eine Programmkennung enthalten.

Ein Hör- oder Fernsehrundfunksignalempfänger, der im Oberbegriff des Anspruchs 1 näher bezeichneten Art, der erfindungsgemäß entsprechend dem Kennzeichen des Anspruchs 1 ausgebildet ist, löst eine automatische Neuprogrammierung auf elegant einfache Art.

Anhand eines Blockschaltbildes wird der Aufbau und die Wirkungsweise eines Ausführungsbeispiels des neuen automatisch programmierbaren Hör- oder Fernsehrundfunksignalempfängers, im dem je jeder Taste ein Programm fest zugeordnet ist, nun näher erläutert.

Der Empfänger enthält einen an die Antenne 1 angeschlossenen Tuner 2, an den die ZF-Stufe 3 mit dem Demodulator angeschlossen ist. Über nachgeschaltete Verstärkerstufen 4, 5 wird das demodulierte NF-Signal dem Lautsprecher 6 oder dem Bildrohr 7 zugeführt. Die zur Steuerung des letzteren erforderlichen Impulsschaltungen sind nicht näher dargestellt.

An den Demodulator in der ZF-Stufe ist ein Kennungsdecoder 8 angeschlossen, der aus dem empfangenen Signal die begleitende Programmkennung herausfiltert. Für diese Programmkennung gibt es inzwischen zahlreiche Vorschläge und Versuchssendungen. Auch die Bereichskennung im Verkehrsfunk kann in gewisser Weise zu diesen gezählt werden.

Die Durchstimmung des Tuners 2 kann von einer Suchlaufschaltung 9 aus gesteuert werden, für deren Aufbau es zahlreiche Beispiele gibt. Die weitere Funktionsbeschreibung geht davon aus, daß die Suchlaufschaltung einen digitalen Zähler 10 umfaßt, dessen jeweilige Stellung in einem Digitalanalogwandler 11 in eine proportionale Abstimmung für den Tuner umgewandelt wird. Der Zähler 10 ist über einen Schalter 12 mit einem Impulsgeber 13 verbunden. Ist der Schalter 12 geschlossen, dann bewirken die Impulse eine Durchstimmung des gesamten Empfangsbereichs des Tuners. Der Schalter 12 wird beim Empfang eines Senders von einem Diskriminator 14 geöffnet, nämlich dann, wenn eine Trägerfrequenz in den Haltebereich der Suchlaufschaltung gelangt.

Der Tuner ist andererseits auf einen bestimmten Sender einstellbar. Dazu ist der Zähler über einen Wahlschalter 15 mit dem Ausgang eines aus einer Anzahl

. . .

Speichereinheiten 16, 116, 216 verbindbar, in denen bestimmte Zählerstellungen abgelegt sind, die jeweils einem Sender zugeordnet sind.

Die bisher beschriebene Empfängerschaltung mit einer digitalen Suchlaufschaltung gehört zum Stand der Technik. Ebenso ist es bekannt, wie die Speichereinheiten zu programmieren sind, zum Beispiel dadurch, daß die Zählerstellung beim Empfang eines über die Suchlaufschaltung eingestellten Senders in den ausgewählten Speicher eingelesen wird.

Im Ausführungsbeispiel der Erfindung ist nun an dieser Stelle, nämlich in jedem Speichereingang, ein Filter 17, 117, 217 ... vorgesehen. Jedes Filter ist nur bei einer zugeordneten Programmkennung durchlässig, d. h. das Einlesen einer Zählerstellung in einen bestimmten Speicher ist nur dann möglich, wenn der bei dieser Zählerstellung empfangene Sender die dem Filter zugeordnete Programmkennung ausstrahlt. Die Speichereingänge sind über eine Steuereinheit 18 nacheinander mit dem Leseausgang des Zählers verbindbar.

Jedes Filter umfaßt daher einen Speicher 19 für die Sollkennung und einen mit diesem verbundene Vergleichsstufe 20, die andererseits mit dem Kennungsdecoder 8 verbunden ist und eine Torschaltung 21, die im Eingangskreis des Speichers 16 liegt. Bei Übereinstimmung der Sollkennung mit der vom Kennungsdecoder 8 ermittelten Kennung des gerade empfangenen Senders ist die Torschaltung 21 durchgeschaltet. Somit kann die Stellung des Zählers 10 in den Speicher 16 eingelesen werden, wenn vorgeschaltete Steuereinheit 18 betätigt wird.

...

PLI-Hi Eilers/TEX2-Kh            — 4 —                    27.1.1983
                                                        R.Nr. 1769

Die Steuereinheit 18 ist zwischen den Zählerausgang und den Eingang der Speichereinheit zum Auslösen des Befehls "neu programmieren" eingefügt. Diese Steuereinheit umfaßt einen als Befehlsgeber dienenden Schalter 23, der von dem Gerätebesitzer zu bedienen ist. Dieser Schalter 23 setzt ein umlaufendes Schaltwerk 22 in Betrieb, das nacheinander die Speichereinheiten 16, 116 ... aufruft, d. h. mit dem Ausgang des Zählers verbindet. In jeder Stellung des Schaltwerkes wird die Zählerstellung einmal ausgelesen. Diese Zählerstellung wird jedoch nur in die Speichereinheit eingelesen, wenn dessen zugeordnetes Filter durchgeschaltet ist.

Das hier beschriebene Ausführungsbeispiel kann auf Einrichtungen mit Feldstärkevergleich zwischen verschiedenen Sendern des gleichen Programms, wie sie bereits vorgeschlagen wurden, verzichten; denn der Gerätebenutzer will in der Regel jedes Programm nur mit der, stets gleichbleibenden Taste einschalten. Beim Programmieren läßt nun der Benutzer zunächst mit der Suchlaufschaltung das gesamte Empfangsspektrum Sender für Sender einmal abfragen. Dabei gewinnt er einen Überblick über die Programme, die er empfangen kann. Bei jedem neuen Programm betätigt er einmal den Befehlsgeber. Damit ist dieses Programm automatisch unter der zugeordneten Taste abgelegt.

Wird das gleiche Programm auch von einem anderen Sender übertragen und hält der Gerätebesitzer die Übertragungsqualität bei diesem Sender für besser, dann betätigt er erneut den Befehlsgeber. Dann wird dieser zweite demselben Programm zugeordnete Sender in der entsprechenden Speichereinheit gegen den ersten ausgewechselt. Ist die Übertragungsqualität schlechter, so wird die

. . .

# BLAUPUNKT-WERKE GMBH 32 HILDESHEIM, Robert-Bosch-Straße 200

PLI-Hi Eilers/TEX2-Kh       - 5 -       27.1.1983
R.Nr. 1769

Suchlaufschaltung zum Aufsuchen des nächstfolgenden Senders im Empfangsspektrum über den Schalter 12 wieder eingeschaltet.

0115009

PLI-Hi Eilers/TEX2-Kh                  - 1 -                    27.1.1983
                                                               R.Nr. 1769

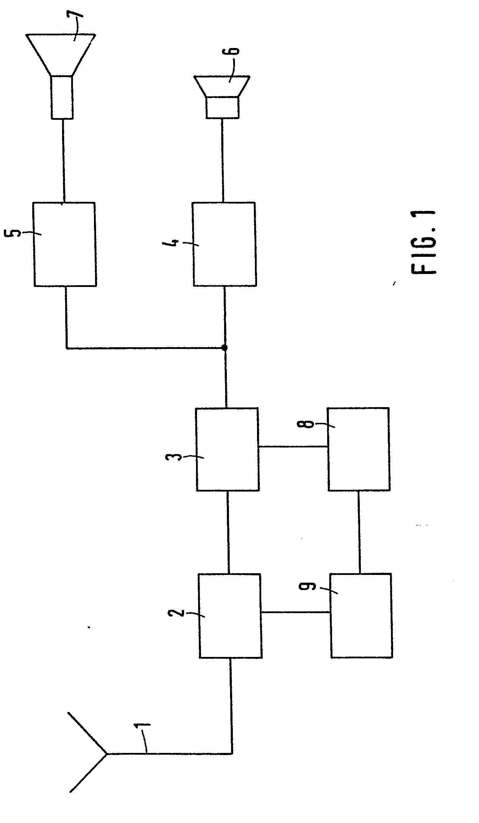

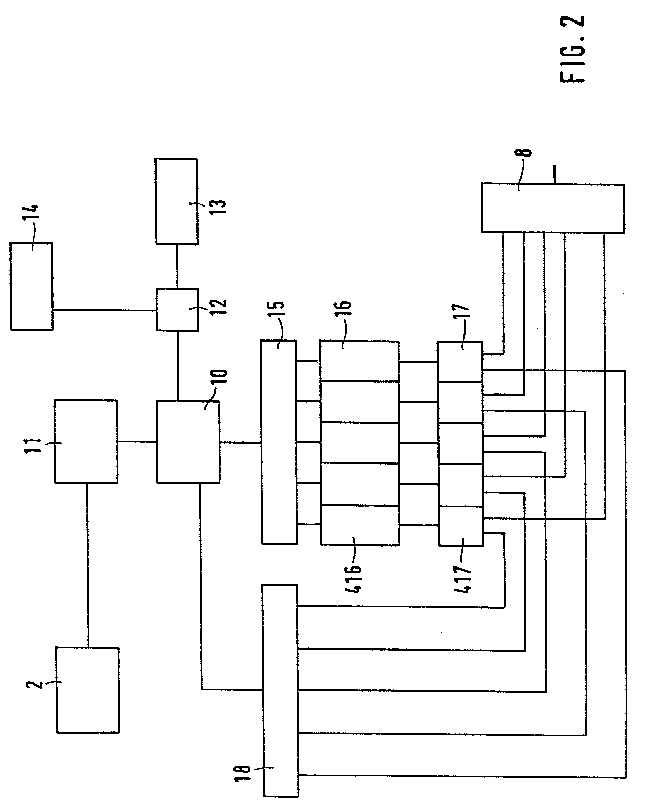

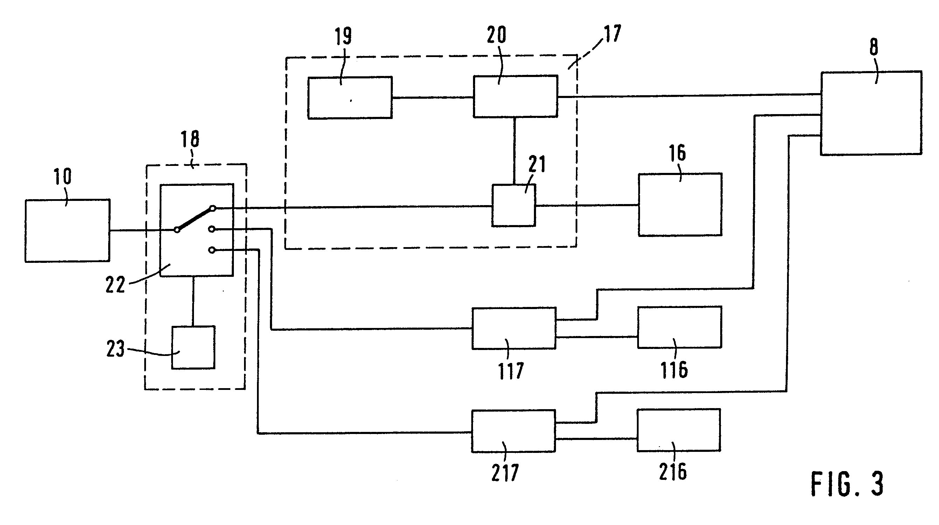

Ansprüche

1.  Hör- oder Fernsehrundfunksignalempfänger mit einem automatisch durchstimmbaren Tuner, mit einem dem ZF-Demodulator nachgeschalteten Detektor für im Signal enthaltene Programmkennungen und mit einem Programmtastenfeld, bei dem jeder Taste ein bestimmtes Programm fest zugeordnet
    ist, dessen Empfangsfrequenz in einem der Taste zugeordneten Speicher
    abgelegt ist, dessen Inhalt im Bedarfsfall veränderbar ist,
    dadurch gekennzeichnet,
    daß jedem Speicher ein Filter (17, 117 ...) vorgeschaltet ist, welches
    nur bei Empfang der Programmkennung des der Taste zugeordneten Programms zur Neuablage der Empfangsfrequenzen durchlässig wird,
    daß alle Filter (17, 117 ...) mit einem umlaufenden Schaltwerk (18)
    verbunden sind, das bei Neuablage einer Empfangsfrequenz diese allen
    Speichern (16, 116 ...) nacheinander anbietet
    und daß jedes Filter (17, 117 ...) mit dem Programmkennungsdetektor (8) verbunden ist.

2.  Hör- oder Fernsehrundfunksignalempfänger nach Anspruch 1,
    dadurch gekennzeichnet,
    daß jedes Filter (17) einen Speicher (19) für die zugeordnete Sollprogrammkennung und eine Vergleichsstufe (20) umfaßt, die die Sollprogrammkennung mit der am Ausgang des Programmdetektors (8) anstehenden
    Istprogrammkennung vergleicht, und eine von der Vergleichsstufe gesteu-

. . .

# BLAUPUNKT-WERKE GMBH 32 HILDESHEIM, Robert-Bosch-Straße 200

PLI-Hi Eilers/TEX2-Kh                    - 2 -                    27.1.1983
                                                                R.Nr. 1769

erte Torschaltung (21) aufweist, die im Eingangskreis des Speichers (16)

liegt.

0115009

FIG.1

FIG. 2

0115009

FIG. 3